**Europäisches Patentamt**

**European Patent Office**

**Office européen des brevets**

(19)

(11) Veröffentlichungsnummer : **0 042 137**
**B1**

(12) **EUROPÄISCHE PATENTSCHRIFT**

(45) Veröffentlichungstag der Patentschrift :
01.10.86

(51) Int. Cl.⁴ : **H 01 G 13/00**

(21) Anmeldenummer : **81104474.2**

(22) Anmeldetag : **10.06.81**

(54) **Verfahren zum Anbringen und Befestigen von parallel zueinander verlaufenden Stromzuführungsdrähten an gegenüber befindlichen Seitenflächen elektrischer Bauelemente.**

(30) Priorität : **16.06.80 DE 3022590**

(43) Veröffentlichungstag der Anmeldung :
**23.12.81 Patentblatt 81/51**

(45) Bekanntmachung des Hinweises auf die Patenterteilung : **01.10.86 Patentblatt 86/40**

(84) Benannte Vertragsstaaten :
**AT DE FR GB**

(56) Entgegenhaltungen :
**DE-B- 1 162 011**
**DE-B- 2 138 083**

(73) Patentinhaber : **Siemens Aktiengesellschaft Berlin und München**
**Wittelsbacherplatz 2**
**D-8000 München 2 (DE)**
**DE FR GB**
**Siemens Bauelemente OHG**
**Unterlaufenegger Strasse**
**A-8530 Deutschlandsberg (AT)**
**AT**

(72) Erfinder : **Haidinger, Erich**
**Ulrichsberg 20**
**A-8530 Deutschlandsberg (AT)**

**Beschreibung**

Die Erfindung betrifft ein Verfahren zum Anbringen und Befestigen von parallel zueinander verlaufenden Stromzuführungsdrähten an gegenüber befindlichen Seitenflächen elektrischer Bauelemente, indem zunächst ein bandförmiger Transportträger einer automatisch arbeitenden Montageanlage fortlaufend mit je für ein Bauelement bestimmten, einstückig in U-Form ausgeführten Stromzuführungsdrähten derart versehen wird, daß die beiden Schenkel und der sie verbindende Teil der U-Form seitlich über den Rand des Transportträgers hinausragen, danach das Bauelement zwischen den Schenkeln eingeklemmt und dann mit ihnen verlötet wird.

Ein derartiges Verfahren ist in der DE-B-21 38 083 beschrieben, jedoch wird dabei das elektrische Bauelement entweder senkrecht zur Ebene der U-förmigen Anschlußdrähte zwischen diese eingesetzt oder, falls längs der Anschlußdrähte Knickungen eingebracht sind, die zu einer Überkreuzung der Anschlußdrähte führen, werden die Bauelemente zwar in der Ebene der U-Form eingeschoben, jedoch in Richtung der Verschiebung des bandförmigen Transportträgers.

Während beim Einsetzen der Bauelemente zwischen die U-Form senkrecht zu deren Ebene eine sehr genaue Anpassung des Verlaufs der drahtförmigen Stromzuführungen des Bauelements zu Ausfällen beim Einsetzen führen, erfordert das Einschieben in Richtung parallel zur Verschiebungsrichtung des Transportträgers zusätzliche Maßnahmen der automatisch arbeitenden Montage-Anlage beim Öffnen der sich überkreuzenden Teile der Anschlußdrähte.

In der DE-B-11 53 807 ist ein Verfahren zum Anbringen von Stromanschlüssen an elektrische Bauelemente beschrieben, bei dem die Ausgestaltung der Stromzuführungen und ihre Befestigung am bandförmigen Trägerstreifen derart vorgenommen wird, daß die herausragenden freien Enden eine Klemmwirkung gewährleisten, die Bauelemente zwischen diese freien Enden durch Klemmwirkung befestigt werden und dann die Stromzuführungen an den Bauelementen elektrisch leitend und mechanisch befestigt werden. Die für ein Bauelement bestimmten Stromzuführungen sind einstückig, z. B. in Haarnadelform ausgebildet.

Dieses Verfahren eignet sich nur zum Anbringen und Befestigen von Stromzuführungsdrähten an elektrische Bauelemente, die scheibenförmig sind und bei denen die Stromzuführungsdrähte an den gegenüberliegenden großen Seitenflächen erfolgt.

In der DE-B-11 62 011 ist ein scheibenförmiges elektrisches Impedanzelement mit Stromzuführungsdrähten und ein Verfahren zum Anbringen von Stromzuführungsdrähten an ein solches Element beschrieben, bei dem die Stromzuführungsdrähte dem Umriß der Scheibe folgen, sich bis auf kurzen Abstand nähern und dann zusammen vom Scheibenrand abbiegen, wobei etwa an dieser Stelle ein Isolierring vorgesehen ist, durch den die Drähte hindurchlaufen und in welchem diese Drähte mittels eines Teiles einer die Scheibe allseitig umhüllenden Lackschicht verankert sind.

Bei diesem Verfahren werden zwar die Stromzuführungsdrähte an den gegenüberliegenden schmalen Seiten eines scheibenförmigen Bauelements angebracht, jedoch ist das für diese Art der Anbringung der Stromzuführungsdrähte erforderlich Verfahren nicht mit automatisch arbeitenden Montage-Anlagen durchzuführen, bei denen ein bandförmiger Transportträger verwendet wird.

Im älteren Patent gemäß DE-A-2 948 319 (Patentanmeldung P 29 49 319.0 vom 30.11.1979) ist ein Verfahren zum Anbringen und Befestigen von Stromzuführungsdrähten an elektrischen Bauelementen der hier eingangs erläuterten Art beschrieben, bei dem folgende Verfahrensschritte vorgesehen sind :

a) der seitlich über den Rand des Transportträgers hinausragende Teil der U-förmig ausgeführten, parallelen Stromzuführungsdrähte wird im dem Einschieben in die Schlitze des Transportträgers folgenden Arbeitsschritt zu einem Teil derart um einen Winkel $\alpha$ von etwa 90° einen Verbindungsbügel bildend abgebogen, daß der andere Teil der beiden Drähte in ihrer bisherigen Ebene verbleibt und auf diese Weise das in Richtung der Stromzuführungsdrähte und in der Ebene des Transportträgers erfolgende Einschieben des Bauelementes ermöglicht ;

b) beim folgenden Arbeitsschritt werden die Bauelemente zwischen die Stromzuführungsdrähte eingeschoben und in an sich bekannter Weise mit ihnen verlötet ;

c) beim nächsten Arbeitsschritt wird der Verbindungsbügel in der Nähe des Bauelementes abgetrennt ;

d) anschließend werden die Bauelemente mit den Stromzuführungsdrähten in an sich bekannter Weise geprüft, ggf. umhüllt und fertiggestellt.

In einer bevorzugten Ausführungsform wird am Übergang vom rechtwinklig abgebogenen Teil der U-Form zu den ebenverbliebenen Schenkeln durch Knickungen eine sich verjüngende Einschiebehilfe gebildet. Ohne diese Einschiebehilfe ist es erforderlich, die Stromzuführungsdrähte mit einem besonderen Werkzeug zu spreizen, dann die Bauelemente einzulegen und auf diese Weise den klemmenden Halt zu gewährleisten.

Das Verfahren des älteren Patentes hat sich insbesondere in der bevorzugten Ausführungsform, d. h. mit durch Knickungen gebildeter Einschiebehilfe, bewährt, weil die Abmessungen des Bauelementes, insbesondere Schwankungen seiner Länge, dabei unkritisch sind. Dennoch ist das rechtwinklige Abbiegen ein zusätzlicher Arbeitsschritt, der aber für diese Fälle gerechtfertigt ist.

Der Begriff « elektrische Bauelemente » wird im Rahmen der vorliegenden Erfindung für elektrische Widerstände, z. B. keramische Kaltleiter, elektrische Kondensatoren, insbesondere Vielschicht-Kondensatoren mit einem keramischen Dielektrikum, sowie allgemein für solche elektrische Bauteile benutzt, die einen Körper enthalten, der entweder selbst Teil des elektrischen Bauteils ist (Kondensator, Widerstände, Halbleiter) oder als Trägerplatte für andere elektrische Bauelemente dient (z. B. Schichtschaltungen), wobei an diesen Trägerkörper an gegenüberliegenden Seiten je ein Stromzuführungsdraht zu befestigen ist.

Beim Anbringen und Befestigen von Stromzuführungsdrähten an elektrische Bauelemente mittels automatisch arbeitender Montage-Anlage müssen die einzelnen Arbeitsschritte derart bemessen und aufeinander abgestimmt sein, daß eine hohe Taktzeit der Montage-Anlage ermöglicht wird. Die Taktzeit der Montage-Anlage richtet sich nach dem zeitaufwendigsten bzw. schwierig durchzuführenden Arbeitsschritt.

Während das Formen der einzelnen Anschlußdrähte eines Bauelemente zu einer U-Form, das Einsetzen derselben in Schlitze eines Transportträgerbandes, die weitere Verformung dieser Anschlußdrähte, das spätere Verlöten derselben mit den Metallflächen des elektrischen Bauelements, das Prüfen und das Umhüllen mit einer Schutzschicht Arbeitsschritte sind, die eventuell durch mehrfache Unterteilung schnell durchgeführt werden können, bereitet das Einsetzen des elektrischen Bauelements zwischen die Stromzuführungsdrähte und der vorübergehende Halt derselben bis zum Lötvorgang Schwierigkeiten, die dazu führen, daß diese Arbeitsschritte bestimmend für die Gesamttaktzeit der Montage-Anlage sind.

Es kommt hinzu, daß die elektrischen Bauelemente nicht stets konstante äußere Abmessungen aufweisen, so daß das Einsetzen zwischen die Stromzuführungsdrähte für den vorübergehenden Halt Schwierigkeiten beispielsweise insofern bereitet, daß der notwendige vorübergehende Halt nicht gewährleistet ist und es deshalb nicht zu einer elektrisch leitenden und mechanisch festen Verbindung kommt. Wenn die elektrischen Bauelemente, die mit Stromzuführungsdrähten zu versehen sind, aufgrund ihrer elektrischen Erfordernisse unterschiedliche Abmessungen haben, so muß — selbst wenn es sich nur um kleine Unterschiede handelt — stets die Anlage umgestellt werden, was aber insbesondere bei kleineren Stückzahlen zu Stillstandzeiten führt.

Wenn innerhalb einer vorgegebenen Bauform des elektrischen Bauelementes, insbesondere eines keramischen Vielschichtkondensators, durch den Herstellungsgang dieser Bauelemente erreicht wird, daß praktisch keine fertigungsbedingten Schwankungen insbesondere der Länge L des Bauelementes, die zwischen den mit Metallbelegungen versehenen gegenüberliegenden Stirnflächen gemessen wird, auftreten, dann ist es nicht nötig, die beim Verfahren des älteren Patentes beschriebene Abbiegung um 90° und das Aufspreizen mit einem gesonderten Werkzeug oder das Bilden einer Einschiebehilfe vorzunehmen. Bei zueinander parallel verlaufenden Stromzuführungen, die für den Herstellungsgang durch einen U-Bügel miteinander verbunden sind, ist es für einen klemmenden Halt des Bauelementes zwischen den Stromzuführungsdrähten erforderlich, diese aufzuspreizen. Das Aufspreizen mit einem gesonderten Werkzeug des Bedrahtungsautomaten stellt aber einen gesonderten Arbeitsschritt dar, dem das Einsetzen des Bauelementes und das Entfernen des Aufspreizwerkzeuges folgen muß.

Der vorliegenden Erfindung liegt die Aufgabe zugrunde, ein Verfahren anzugeben, das auf einfache Weise automatisch durchführbar ist für den Fall, daß fertigungsbedingte Schwankungen insbesondere der Länge des Bauelementes praktisch nicht auftreten.

Zur Lösung dieser Aufgabe ist das Verfahren der eingangs angegebenen Art erfindungsgemäß durch die Merkmale des Patentanspruches gekennzeichnet.

Dieses Verfahren gewährleistet durch die Wahl der Abmessungen, daß das Bauelement selbst als Aufspreizwerkzeug benutzt wird, so daß wenigstens zwei zusätzliche Arbeitsschritte des Bedrahtungsverfahrens entfallen können. Das Verfahren hat sich in der Praxis bewährt und wird mit einer automatisch arbeitenden Anlage durchgeführt, deren einzelne Stationen mit an sich bekannten Vorrichtungen und Vorrichtungselementen durchgeführt werden.

Die Erfindung wird nachfolgend anhand der beigefügten Figuren erläutert.

Es zeigen

Figur 1 den bandförmigen Transportträger, bei dem die einzelnen Arbeitsschritte eingezeichnet sind, hier jedoch in einer beträchtlich gekürzten Form, denn in der praktischen Ausführung gehören zu jedem Arbeitsschritt eine Vielzahl von gleichgeformten Stromzuführungsdrähten, während hier jeweils nur wenige solche Einheiten dargestellt sind ;

Figur 2 ein einzelnes Bauelement mit Stromzuführungsdrähten entsprechend Fig. 1 im Arbeitsschritt D ;

Figur 3 einen Schnitt längs der Linie III-III in Fig. 1, wodurch die Abmessungsverhältnisse dargestellt werden.

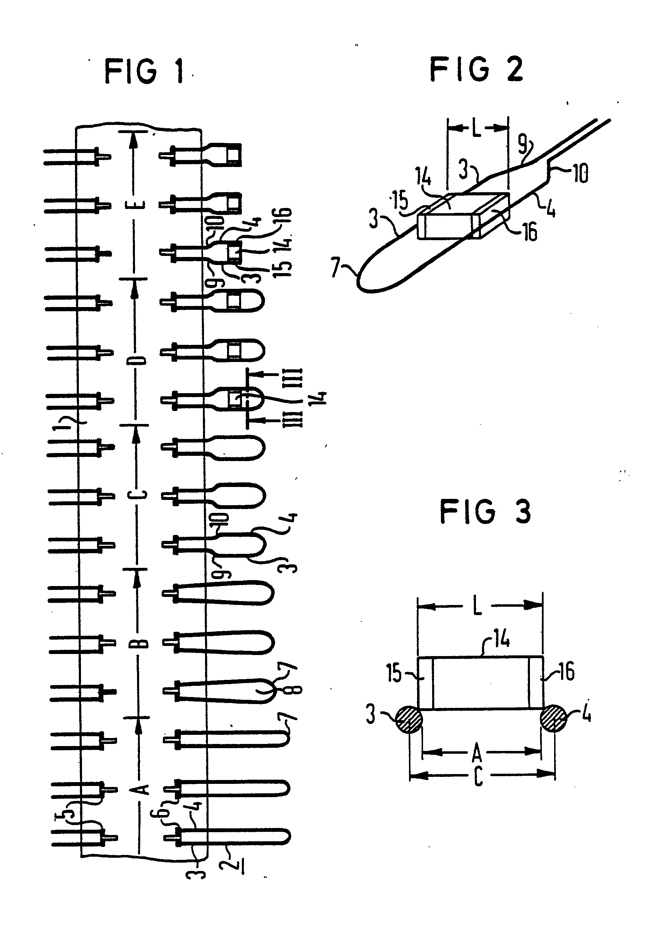

In Fig. 1 ist mit 1 der bandförmige Trägerstreifen bezeichnet. Die für ein elektrisches Bauelement bestimmten Stromzuführungsdrähte 3 und 4 sind in Schlitze 5 und 6 des Trägerstreifens 1 eingesetzt. Über den Rand des Transportträgers 1 ragt der Teil 2 der U-förmig ausgeführten, parallelen Stromzuführungsdrähte 3 und 4 hinaus. Das Einschieben dieser einstückigen U-Form erfolgt an der automatisch arbeitenden Anlage in an sich bekannter Weise, und zwar derart, daß — entsprechend dem Arbeitstakt der Montage-Anlage — von einer Vorratsrolle Draht abgezogen wird, der auf die erforderliche Länge abgeschnitten, durch eine in der Ebene des Transportträgers 1 und senkrecht zur Transportrichtung wirkenden Metallzunge in die Schlitze einschoben wird.

Derartige Vorrichtungen sind beispielsweise in den US-A-2 953 840 und US-A-3 315 331 beschrieben.

Im weiteren Verlauf der Arbeitsschritte wird der seitlich über den Rand des Transportträgers 1 hinausragende Teil 2 zu einer Schlaufe aufgebogen, wobei der Radius des U-Bogens 7 vergrößert wird und die Stromzuführungsdrähte 3, 4 einen sich vom Transportband 1 weg öffnenden Winkel zueinander bilden.

Danach wird die Schlaufe 8 in der Nähe des Randes des Transportträgers 1 mit Knickungen 9 und 10 versehen, die einerseits dazu dienen, Lackumhüllungen des Bauelementes längs der Drähte zu begrenzen, und andererseits für die Einhaltung des Rastermaßes der Stromzuführungsdrähte sorgen. Die Knickungen 9 und 10 werden so bemessen, daß die Stromzuführungsdrähte 3 und 4 wiederum parallel zueinander verlaufen und in den U-Bügel übergehen, jedoch mit größerem Abstand zueinander als bei dem hinausragenden Teil 2. Der Abstand A (Fig. 3) der Stromzuführungsdrähte 3 und 4 voneinander ist kleiner als die Länge L des Bauelementes 14, gemessen zwischen den Stirnseiten der mit Metallschichten 15 und 16 versehenen Enden des Bauelements 14. Der Mittelpunktsabstand C der Stromzuführungsdrähte 3 und 4 ist größer als die Länge L des Bauelementes 14. Aufgrund dieser Bemessung kann das Bauelement selbst die Stromzuführungsdrähte 3 und 4 auseinanderspreizen, und zwar auf das für den klemmenden Halt ausreichende Maß.

Die Bearbeitung des über den Rand des Transportträgers 1 hinausragenden Teiles der miteinander U-förmig verbundenen Stromzuführungsdrähte 3 und 4 erfolgt in den Arbeitsschritten A, B und C gemäß Fig. 1.

Im Arbeitsschritt D wird das Bauelement 14 in der bei der Erläuterung der Fig. 3 geschilderten Weise eingesetzt.

Die Fig. 2 zeigt ein derart zwischen den Stromzuführungen 3 und 4 klemmend gehaltenes Bauelement 14 mit den Metallisierungen 15 und 16. Die Stromzuführungsdrähte 3 und 4 sind durch den U-Bügel 7 miteinander verbunden und gehen über die Knickungen 9 und 10 in parallel geführte Teile über, die in den Transportträger eingesteckt sind.

Im Arbeitsschritt D erfolgt auch noch das Verlöten der metallischen Stromzuführungsbelegungen 15 und 16 des Bauelementes 14 mit den Stromzuführungsdrähten 3 und 4, und zwar vorzugsweise durch Schwall-Lötung, die an sich bekannt ist und darin besteht, daß aus einem flüssigen Lötbad ein Strahl aus Lot herausgefördert wird, der an den miteinander zu verlötenden Teilen vorbeigeführt wird und wiederum in das Lötbad zurückkehrt.

Im darauffolgenden Arbeitsschritt E werden der verbindende U-Bogen 7 zusammen mit Teilen der Stromzuführungsdrähte 3 und 4 in der Nähe des Bauelements 14 abgetrennt, so daß eine elektrische Verbindung zwischen den Stromzuführungsbelegungen 15 und 16 (die als Lötanschlüsse dienen) nicht mehr besteht. Die elektrischen Bauelemente 14 werden dann in an sich bekannter Weise auf ihre elektrischen Werte geprüft, ggf. umhüllt und anderweitig fertiggestellt, beispielsweise verpackt.

Durch die vorliegende Erfindung wird die ihr zugrundeliegende Aufgabe in voll befriedigender Weise gelöst ; insbesondere konnte die Taktzeit des Automaten erhöht werden, so daß die automatisch arbeitende Montageanlage nunmehr mit einer Taktgeschwindigkeit von 60 Takten/Minute und mehr betrieben werden kann.

Es ist selbstverständlich, daß die einzelnen Arbeitsgänge, wie Einschieben der Stromzuführungsdrähte 3, 4 in die Schlitze 5, 6 des Transportträgers 1, das Bilden der Schlaufe 8, die Erzeugung der Knickungen 9 und 10, das Einschieben der Bauelemente 14, das Verlöten der Bauelemente 14 mit den Stromzuführungsdrähten 3 und 4 sowie die nachfolgenden Arbeitsschritte jeweils gleichzeitig ablaufen, während die oben beschriebene Reihenfolge nur während der Einlaufphase der Montageanlage durchgeführt wird.

**Patentanspruch**

Verfahren zum Anbringen und Befestigen von parallel zueinander verlaufenden Stromzuführungsdrähten an gegenüber befindlichen Seitenflächen elektrischer Bauelemente, indem zunächst ein bandförmiger Transportträger einer automatisch arbeitenden Montage-Anlage fortlaufend mit je für ein Bauelement bestimmten, einstückig in U-Form ausgeführten Stromzuführungsdrähten derart versehen wird, daß die beiden Schenkel und der sie verbindende Teil der U-Form seitlich über den Rand des Transportträgers hinausragen, danach das Bauelement zwischen den Schenkeln eingeklemmt und dann mit ihnen verlötet wird, gekennzeichnet durch folgende Verfahrensschritte :

a) der Abstand (A) zwischen den Schenkeln des seitlich über den Rand des Transportträgers (1) hinausragenden Teiles (2) der U-förmig ausgeführten, parallelen Stromzuführungsdrähte (3, 4) wird durch Herstellen von Abbiegungen (9, 10) so eingestellt, daß er kleiner als die Länge (L) des Bauelementes (14) ist und der Mittelpunktabstand (C) dieser Teile größer ist als die Länge (L) des Bauelementes (14),

b) beim folgenden Arbeitsschritt werden die Bauelemente (14) senkrecht zur Ebene der U-Form der Stromzuführungsdrähte (3, 4) und zur Ebene des Transportträgers (1) eingeschoben, spreizen dabei aufgrund der gewählten Abmessungen die Stromzuführungsdrähte (3, 4) auseinander und werden von diesen klemmend gehalten, wonach in an sich bekannter Weise die Verlötung der Bauelemente (14) mit den Stromzuführungsdrähten (3, 4) erfolgt ;

c) beim nächsten Arbeitsschritt werden die Verbindungsbügel (7) in der Nähe des Bauelements (14) abgetrennt ;

d) anschließend werden die Bauelemente (14) mit den Stromzuführungsdrähten (3, 4) in an sich bekannter Weise geprüft, ggf. umhüllt und fertiggestellt.

## Claim

A method of mounting and fixing parallel current supply leads on opposite sides of electrical components, wherein, firstly, a strip-shaped transport carrier of an automatically-operating assembly system is consecutively provided with current supply leads for each respective component designed in one piece to be U-shaped, in such manner that the two flanks and the part of the U connecting these flanks protrude laterally beyond the edge of the transport carrier, and the component is subsequently clamped between the flanks and then soldered thereto, characterised by the following steps :

a) the distance (A) between the flanks of the part (2) of the U-shaped parallel current supply leads (3, 4) which protrudes laterally beyond the edge of the transport carrier (1), is so adjusted by the production of bends (9, 10) that it is smaller than the length (L) of the component (14), and the distance (C) from the centre point of these parts is greater than the length (L) of the component (14) ;

b) in the following operational step, the components (14) are inserted at right angles to the plane of the U-shape of the current supply leads (3, 4) and to the plane of the transport carrier (1), thereby forcing the current supply leads (3, 4) apart as a result of the selected dimensions, and are clamped by said leads, whereupon the components (14) are soldered to the current supply leads (3, 4) in a manner known *per se* ;

c) in the next operational step, the connecting clips (7) are separated in the vicinity of the components (14) ;

d) the components (14), together with the current supply leads (3, 4), are subsequently tested in known manner, possibly coated and finished.

## Revendication

Procédé pour apposer et fixer des fils d'amenée du courant qui s'étendent parallèlement entre eux, sur des surfaces latérales opposées de composants électriques, du type dans lequel un support de transport, en forme d'une bande, d'une installation de montage opérant automatiquement, est pourvu, d'abord, et pour chaque composant, de fils d'amenée du courant réalisés d'une pièce en forme de U, et cela de telle manière que les deux branches et la partie transversale qui les relie, s'étendent au-delà du bord du support de transport, les composants étant ensuite coincés entre lesdites branches et étant ensuite soudés avec celles-ci, caractérisé par les phases opératoires suivantes :

a) la distance (A) entre les branches de la partie (2) des fils parallèles d'amenée du courant (3, 4) réalisés selon un U, et qui s'étend au-delà du bord de transport (1), est ajustée de telle manière par la réalisation de coudes (9, 10), qu'elle est inférieure à la longueur (L) du composant (14), et la distance (C) entre les centres de ces fils est supérieure à la longueur (L) du composant (14) ;

b) lors de la phase opératoire suivante, les composants sont insérés perpendiculairement au plan de la forme en U des fils d'amenée du courant (3, 4) et au plan du support de transport (1), ils écartent l'un de l'autre les fils d'amenée du courant (3, 4), en raison des dimensions choisies, et sont maintenus en position bloquée par ces fils, après quoi, et de façon connue, on opère la soudure des composants (14) avec les fils d'amenée du courant (3, 4) ;

c) au cours de la phase opératoire suivante on sépare les étriers de liaison dans le voisinage des composants (14) ;

d) puis, les composants (14), comportant les fils d'amenée du courant (3, 4) sont testés de manière connue et éventuellement enrobés et terminés.

# FIG 1

# FIG 2

# FIG 3